(19) Europäisches Patentamt
European Patent Office
Office européen des brevets

(11) **EP 3 387 166 B1**

(12) **EUROPÄISCHE PATENTSCHRIFT**

(45) Veröffentlichungstag und Bekanntmachung des Hinweises auf die Patenterteilung:
**18.11.2020 Patentblatt 2020/47**

(21) Anmeldenummer: **16805805.5**

(22) Anmeldetag: **02.12.2016**

(51) Int Cl.:
**C30B 29/06** (2006.01)          **C30B 15/20** (2006.01)
**C01B 33/02** (2006.01)

(86) Internationale Anmeldenummer:
**PCT/EP2016/079572**

(87) Internationale Veröffentlichungsnummer:
**WO 2017/097675 (15.06.2017 Gazette 2017/24)**

(54) **HALBLEITERSCHEIBE AUS EINKRISTALLINEM SILIZIUM UND VERFAHREN ZU DEREN HERSTELLUNG**

SEMICONDUCTOR WAFER MADE OF MONOCRYSTALLINE SILICON, AND METHOD FOR PRODUCING THE SAME

PLAQUETTE DE SEMI-CONDUCTEUR EN SILICIUM MONOCRISTALLIN ET SON PROCÉDÉ DE FABRICATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.12.2015 DE 102015224983**

(43) Veröffentlichungstag der Anmeldung:
**17.10.2018 Patentblatt 2018/42**

(73) Patentinhaber: **Siltronic AG**
**81737 München (DE)**

(72) Erfinder:
• **MÜLLER, Timo**
**84489 Burghausen (DE)**
• **HEUWIESER, Walter**
**84533 Stammham (DE)**
• **SKROBANEK, Michael**
**09599 Freiberg (DE)**
• **KISSINGER, Gudrun**
**15326 Lebus (DE)**

(74) Vertreter: **Staudacher, Wolfgang**
**Siltronic AG**
**Intellectual Property -LP 244**
**Johannes-Hess-Str. 24**
**84489 Burghausen (DE)**

(56) Entgegenhaltungen:
**EP-A1- 1 914 795          US-A1- 2013 175 726**
**US-A1- 2014 044 945**

• **KISSINGER G ET AL: "300 mm Czochralski silicon wafers optimized with respect to voids with laterally homogeneous oxygen precipitation", PHYSICA B: CONDENSED MATTER, Bd. 407, Nr. 15, 26. August 2011 (2011-08-26), Seiten 2993-2997, XP028927821, ISSN: 0921-4526, DOI: 10.1016/J.PHYSB.2011.08.055**

**Beschreibung**

Gegenstand der Erfindung ist eine Halbleiterscheibe aus einkristallinem Silizium, die Sauerstoff, Stickstoff und Wasserstoff enthält und ein Verfahren zur Herstellung einer solchen Halbleiterscheibe. Auf Grund ihrer Eigenschaften eignet sich die Halbleiterscheibe insbesondere als Substratscheibe, auf deren oberer Seitenfläche (Vorderseite) eine epitaktische Schicht abgeschieden wird. Eine Halbleiterscheibe mit abgeschiedener epitaktischer Schicht wird auch epitaktische Halbleiterscheibe genannt.

Sauerstoff spielt eine wichtige Rolle bei der Bildung von BMD-Defekten (BMDs, Bulk Micro Defects). BMDs sind Sauerstoffpräzipitate, zu denen BMD-Keime im Zuge einer Wärmebehandlung wachsen. Sie wirken als interne Getter, also als energetische Senken für Verunreinigungen, und sind daher grundsätzlich von Vorteil. Eine Ausnahme bildet ihre Präsenz an Stellen, an denen beabsichtigt ist, elektronische Bauelemente unterzubringen. Um zu vermeiden, dass BMDs an solchen Stellen entstehen, kann eine epitaktische Schicht auf der Halbleiterscheibe abgeschieden und vorgesehen werden, die elektronischen Bauelemente in der epitaktischen Schicht unterzubringen.

Zu beachten ist allerdings, dass das Abscheiden der epitaktischen Schicht auf der Halbleiterscheibe eine thermische Belastung der Halbleiterscheibe bedeutet, im Zuge derer kleinere BMD-Keime aufgelöst werden. Die kleineren BMD-Keime stehen dann nicht mehr zur Verfügung, um nach dem Abscheiden der epitaktischen Schicht zu BMDs wachsen zu können. Eine Möglichkeit dem entgegenzuwirken, besteht darin, die Halbleiterscheibe vor dem Abscheiden der epitaktischen Schicht einer Wärmebehandlung zu unterziehen, um kleinere BMD-Keime zu stabilisieren oder BMDs zu bilden, die nicht mehr aufgelöst werden. Eine solche Wärmebehandlung ist jedoch mit zusätzlichen Kosten verbunden. Alternativ oder ergänzend dazu kann die Konzentration an Sauerstoff im Einkristall vergleichsweise hoch gewählt werden, um auch nach dem Abscheiden der epitaktischen Schicht eine möglichst hohe Dichte von BMD-Keimen in der Halbleiterscheibe zu erhalten. In der US 2006/0150894 A1 ist ein Verfahren beschrieben, demzufolge der Einkristall, von dem die Halbleiterscheibe stammt, einer Wärmebehandlung unterzogen wird, um BMDs zu bilden.

Wird der Einkristall, von dem die Halbleiterscheibe stammt, gemäß der Czochralski-Methode (CZ-Methode) aus einer Schmelze gezogen, die in einem Quarztiegel gehalten wird, bildet das Tiegelmaterial die Quelle für Sauerstoff, der in den Einkristall und die daraus gewonnene Halbleiterscheibe eingebaut wird. Die Konzentration an Sauerstoff, die eingebaut wird, lässt sich recht genau kontrollieren, beispielsweise durch die Regelung des Drucks und des Durchflusses von Argon durch die Ziehapparatur oder durch das Abstimmen von Tiegel- und Keimkristalldrehung während des Ziehens des Einkristalls oder durch Anwendung eines Magnetfelds, das der Schmelze aufgeprägt wird, oder durch eine Kombination dieser Maßnahmen.

Die Gegenwart von Stickstoff im Einkristall fördert die Bildung von BMD-Keimen. Das Dotieren des Einkristalls mit Stickstoff ist daher grundsätzlich geeignet, um höhere Dichten an BMDs zu ermöglichen. Die Konzentration an Stickstoff im Einkristall lässt sich in weiten Grenzen einstellen, beispielsweise durch Lösen eines Stickstoff enthaltenden Materials in der Schmelze oder durch Begasen der Schmelze mit einem Gas, das Stickstoff oder eine Stickstoff enthaltende Verbindung enthält.

Besondere Bedeutung beim Ziehen eines Einkristalls aus Silizium gemäß der CZ-Methode hat auch die Kontrolle des Verhältnisses V/G von Ziehgeschwindigkeit V und axialem Temperaturgradienten G an der Kristallisationsgrenze. Die Ziehgeschwindigkeit V ist die Geschwindigkeit, mit der der wachsende Einkristall von der Schmelze weg nach oben gehoben wird, und der axiale Temperaturgradient G ist ein Maß, das die Änderung der Temperatur an der Kristallisationsgrenze in Richtung des Kristallhubs anzeigt. Art und Konzentration von Punktdefekten (Leerstellen und Silizium-Zwischengitteratome), die im Einkristall dominieren, werden wesentlich vom Quotienten V/G bestimmt. BMDs lassen sich besonders in einem Gebiet entwickeln, in dem die Anzahl an Leerstellen diejenige an Silizium-Zwischengitteratomen übersteigt und in dem deshalb Leerstellen dominieren. Ist beim Kristallisieren des Einkristalls eine vergleichsweise hohe Übersättigung an Leerstellen vorhanden, was bei vergleichsweise hohem Quotienten V/G der Fall ist, bilden die Leerstellen Agglomerate, die beispielsweise als COPs (Crystal Originated Particles) nachgewiesen werden können. Ist V/G und damit die Übersättigung der Leerstellen etwas geringer als es zur Bildung von COPs notwendig wäre, bilden sich anstelle von COPs Keime von OSF-Defekten (Oxidation Induced Stacking Faults). In diesem Fall kristallisiert der Einkristall im OSF-Gebiet. Ist der Quotient V/G noch kleiner, entsteht beim Kristallisieren des Einkristalls ein Gebiet, in dem Leerstellen noch dominieren, das aber als defektfrei gilt, weil darin COPs und OSFs nicht gebildet werden. Ein solches Gebiet wird $P_v$-Gebiet genannt. Bei weiterem Absenken des Quotienten V/G wächst der Einkristall im $P_i$-Gebiet, das ebenfalls als defektfrei gilt, in dem aber Silizium-Zwischengitteratome dominieren.

Der axiale Temperaturgradient G an der Kristallisationsgrenze und dessen radialer Verlauf werden bestimmt durch den Wärmetransport von und zur Kristallisationsgrenze. Der Wärmetransport wird wiederum wesentlich beeinflusst durch die thermischen Eigenschaften der Umgebung des wachsenden Einkristalls, der sogenannten hot zone, und durch die Wärmezufuhr durch eine oder mehrere Heizvorrichtungen.

Ist die Entscheidung gefallen, einen Einkristall in einer bestimmten hot zone zu ziehen, kann der axiale und radiale Verlauf des axialen Temperaturgradient G an der Kristallisationsgrenze mittels Simulationsrechnungen, die die Wärmebilanz berücksichtigen, bestimmt werden. Durch eine entsprechende Gestaltung der hot zone kann auch dafür gesorgt werden, dass der axiale Temperaturgradient G entlang des Radius des Einkristalls einen angestrebten Verlauf hat. Durch das Wachsen des Einkristalls und die Abnahme des Volumens der Schmelze verändern sich mit der Zeit die thermischen Verhältnisse und damit auch der axiale Verlauf des axialen Temperaturgradienten G an der Kristallisationsgrenze. Um den Quotienten V/G auch in axialer Richtung in einem vorgesehenen Bereich zu halten, ist es deshalb erforderlich, die zeitliche Änderung des axialen Temperaturgradienten G durch eine entsprechende Änderung der Ziehgeschwindigkeit V zu kompensieren. Durch das Kontrollieren der Ziehgeschwindigkeit V kann also auch der Quotient V/G kontrolliert werden.

WO 98/45508 A1 ist eine von zahlreichen Veröffentlichungen, die beschreibt, wie der zeitliche Verlauf der Ziehgeschwindigkeit V experimentell ermittelt werden kann, um über die Kontrolle der Ziehgeschwindigkeit V zu erreichen, dass der Quotient V/G während des Wachstums des Einkristalls nahezu unverändert bleibt und der Einkristall in einem vorgesehenen Gebiet wachsen kann. Darüber hinaus sind Nachweismethoden zur Charakterisierung und Unterscheidung von $P_v$-Gebiet und $P_i$-Gebiet beschrieben.

Die EP 1 887 110 A1 betrifft die Herstellung einer Halbleiterscheibe aus einkristallinem Silizium, die Sauerstoff, Stickstoff und Wasserstoff enthält und von einem Einkristall stammt, der im $P_v$-Gebiet gezogen wurde. Es wird berichtet, dass die Gegenwart von Stickstoff und in geringerem Maße die von Wasserstoff es ermöglicht, einen größeren Bereich an Ziehgeschwindigkeiten nutzen zu können, um den Einkristall im $P_v$-Gebiet kristallisieren zu können. Darüber hinaus wird vorgeschlagen, die Konzentration an Sauerstoff in der Halbleiterscheibe vergleichsweise hoch zu wählen und die Halbleiterscheibe einer Wärmebehandlung mittels RTA (rapid thermal anneal) zu unterziehen.

Die US 2011/0084366 A1 befasst sich mit der Herstellung einer Halbleiterscheibe aus einkristallinem Silizium, die Sauerstoff, Stickstoff und Wasserstoff enthält und deren Vorderseite mit einer epitaktischen Schicht bedeckt ist. Aus dem Dokument geht hervor, dass es von Vorteil ist, wenn die Halbleiterscheibe Stickstoff und Wasserstoff in bestimmten Mengen enthält. Die Gegenwart von Wasserstoff wirkt der Bildung von OSFs in der Halbleiterscheibe und davon abgeleiteten Defekten in der epitaktischen Schicht entgegen, ohne gleichzeitig die Wirkung von Stickstoff als Zusatz zu beeinträchtigen, der die Bildung von BMD-Keimen fördert. Andererseits wird darauf hingewiesen, dass die Gegenwart von Wasserstoff in der Halbleiterscheibe für die Bildung von Versetzungen in der epitaktischen Schicht verantwortlich sein kann, und Agglomerate von Leerstellen Ausgangspunkt dieser Versetzungen sind.

Gegenstand der US 2014/0044945 A1 ist eine Halbleiterscheibe aus einkristallinem Silizium, die Sauerstoff, Stickstoff und Wasserstoff enthält, sowie ein Verfahren zur Herstellung einer solchen Halbleiterscheibe. Um die Getter-Effizienz der Halbleiterscheibe über eine längere Zeit zu erhalten, umfasst das Verfahren zwei Wärmebehandlungen, von denen eine als RTA ausgeführt wird.

Die Erfinder der vorliegenden Patentanmeldung widmen sich der Aufgabe, eine Halbleiterscheibe aus einkristallinem Silizium bereitzustellen, deren Eigenschaften sie besonders geeignet machen, sie als Substratscheibe zu verwenden, auf deren Vorderseite eine epitaktische Schicht abgeschieden wird. Insbesondere widmen sie sich der Aufgabe, eine Halbleiterscheibe bereitzustellen, die sich besser für diesen Zweck eignet, als entsprechende Halbleiterscheiben, die in der US 2006/0150894 A1, der EP 1 887 110 A1 und der US 2011/0084366 A1 beschrieben sind. Ist die Vorderseite der bereitgestellten Halbleiterscheibe mit einer epitaktischen Schicht bedeckt, sollen sich während der Herstellung elektronischer Bauelemente möglichst keine Defekte bilden, die in einem Photolithographie-Schritt als Overlay-Defekte erkannt werden, also als lokale Deformationen der Halbleiterscheibe mit abgeschiedener epitaktischer Schicht. Des Weiteren sollen auf der Oberfläche der epitaktischen Schicht möglichst keine Streulichtzentren nachweisbar sein, deren Ursache Zwillingsversetzungen (twin dislocations) sind. Overlay-Defekte und Zwillingsversetzungen beeinträchtigen die Ausbeute an funktionstüchtigen elektronischen Bauelementen.

Die Aufgabe wird gelöst durch eine Halbleiterscheibe aus einkristallinem Silizium mit einem Zentrum, einem Rand und einem Radius R zwischen dem Zentrum und dem Rand, wobei die Halbleiterscheibe aufweist:

eine Sauerstoff-Konzentration von nicht weniger als $4,9 \times 10^{17}$ Atome/cm³ und nicht mehr als $5,85 \times 10^{17}$ Atome/cm³;
eine Stickstoff-Konzentration von nicht weniger als $5 \times 10^{12}$ Atome/cm³ und nicht mehr als $1,0 \times 10^{14}$ Atome/cm³;
eine Wasserstoff-Konzentration von nicht weniger als $3 \times 10^{13}$ Atome/cm³ und nicht mehr als $8 \times 10^{13}$ Atome/cm³;
BMD-Keime, deren über den Radius der Halbleiterscheibe gemittelte Dichte, bestimmt durch IR-Tomographie, nicht weniger als $1 \times 10^5$ cm³ und nicht mehr als $1 \times 10^7$ cm³ beträgt;
Oberflächendefekte, deren längste Diagonale größer als 5 µm ist und deren über den Radius gemittelte Dichte nicht weniger als 1100 cm⁻² beträgt, bestimmt durch optische Mikroskopie nach Wärmebehandlungen der Halbleiterscheibe bei einer Temperatur von 900 °C über einen Zeitraum von 8 h in einer Atmosphäre von Stickstoff und bei einer Temperatur von 1100 °C über einen Zeitraum von 2 h in einer Atmosphäre von Sauerstoff und Wasserstoff; und
BMDs, deren Dichte nicht unter einer unteren Grenze von $5 \times 10^8$/cm³ liegt, bestimmt entlang des Radius von einer radialen Position r = R/3 bis zu einer radialen Position r = R/1,15 durch IR-Tomographie nach Wärmebehandlungen der Halbleiterscheibe bei einer Temperatur von 780 °C über einen Zeitraum von 3 h und bei einer Temperatur von 1000 °C über einen Zeitraum von 16 h, wobei die Wasserstoff-Konzentration, die gemittelte Dichte der BMD-Keime, die gemittelte Dichte der Oberflächendefekte und die Dichte der BMDs durch die in der Beschreibung angegebenen Messmethoden bestimmt werden.

Die Aufgabe wird des Weiteren gelöst durch ein Verfahren zur Herstellung einer Halbleiterscheibe aus einkristallinem Silizium, umfassend das Ziehen eines Einkristalls aus einer Schmelze gemäß der CZ-Methode mit einer Ziehgeschwindigkeit V, wobei die Schmelze mit Sauerstoff, Stickstoff und Wasserstoff dotiert wird und der Einkristall an einer Kristallisationsgrenze wächst;

das Ziehen des Einkristalls in einer Atmosphäre, die Wasserstoff enthält, wobei der Partialdruck des Wasserstoffs nicht weniger als 5 Pa und nicht mehr als 15 Pa beträgt;

das Kontrollieren des Einbaus von Sauerstoff, Stickstoff und Wasserstoff in einem Abschnitt des Einkristalls mit einheitlichem Durchmesser derart, dass die Sauerstoff-Konzentration nicht weniger als $4,9 \times 10^{17}$ Atome/cm$^3$ und nicht mehr als $5,85 \times 10^{17}$ Atome/cm$^3$, die Stickstoff-Konzentration nicht weniger als $5 \times 10^{12}$ Atome/cm$^3$ und nicht mehr als $1,0 \times 10^{14}$ Atome/cm$^3$ und die Wasserstoff-Konzentration nicht weniger als $3 \times 10^{13}$ Atome/cm$^3$ und nicht mehr als $8 \times 10^{13}$ Atome/cm$^3$ betragen;

das Kontrollieren der Ziehgeschwindigkeit V derart, dass sie innerhalb einer Spanne $\Delta V$ liegt, innerhalb derer der Einkristall im Abschnitt mit einheitlichem Durchmesser in einem $P_v$-Gebiet wächst, wobei die Ziehgeschwindigkeit V in einem Teilbereich der Spanne liegt, der 39 % der Spanne umfasst und eine niedrigste Ziehgeschwindigkeit der Spanne 26 % größer ist, als eine Ziehgeschwindigkeit am Übergang vom $P_v$-Gebiet zu einem $P_i$-Gebiet; und

das Abtrennen der Halbleiterscheibe vom Abschnitt des Einkristalls mit einheitlichem Durchmesser, wobei die Spanne $\Delta V$ durch die in der Beschreibung angegebene Messmethode bestimmt wird.

Eine Wärmebehandlung der Halbleiterscheibe oder des Einkristalls, die vor dem Abscheiden einer epitaktischen Schicht auf der Halbleiterscheibe durchgeführt wird, um BMD-Keime zu erzeugen und/oder zu stabilisieren, die beim Abscheiden der epitaktischen Schicht nicht aufgelöst werden, ist kein Bestandteil des Verfahrens.

Die Erfinder vermuten als Ursache für die Entstehung von Overlay-Defekten Spannungen im Kristallgitter auf Grund von Überhöhungen der Dichte von BMDs. Solche Spannungen können auch auftreten, falls der radiale Verlauf der Dichte von BMDs zu inhomogen ist. Darüber hinaus kann auch eine zu geringe Dichte von BMDs Overlay-Defekte hervorrufen, weil in einem solchen Fall die Wirkung von BMDs, Gleitungen im Kristallgitter zu blockieren, das sogenannte Pinning, zu schwach ausgeprägt ist. Als Ursache für die Entstehung von Zwillingsversetzungen werden größere BMD-Keime vermutet, die aber noch zu klein sind, um OSF-Defekte bilden zu können.

Die bereitgestellte Halbleiterscheibe muss deshalb bestimmte Voraussetzungen erfüllen. Bezüglich der Konzentrationen von Sauerstoff, Stickstoff und Wasserstoff hat die bereitgestellte Halbleiterscheibe folgende Eigenschaften: Die Sauerstoff-Konzentration der Halbleiterscheibe beträgt gemäß new ASTM nicht weniger als $4,9 \times 10^{17}$ Atome/cm$^3$ und nicht mehr als $5,85 \times 10^{17}$ Atome/cm$^3$, die Stickstoff-Konzentration nicht weniger als $5 \times 10^{12}$ Atome/cm$^3$ und nicht mehr als $1,0 \times 10^{14}$ Atome/cm$^3$ und die Wasserstoff-Konzentration nicht weniger als $3 \times 10^{13}$ Atome/cm$^3$ und nicht mehr als $8 \times 10^{13}$ Atome/cm$^3$.

Ist die Sauerstoff-Konzentration niedriger als die untere Grenze, entstehen nach dem Abscheiden einer epitaktischen Schicht auf der Halbleiterscheibe und nach einer Wärmebehandlung, die BMD-Keime zu BMDs wachsen lässt, BMDs, deren Dichte entlang des Radius der Halbleiterscheibe zu inhomogen ist und stellenweise oder vollständig unter $3 \times 10^8$ /cm$^3$ bleibt. Um eine ausreichende Wirkung als interner Getter entfalten zu können, sollte die Dichte von BMDs nicht weniger als $3 \times 10^8$ /cm$^3$ sein. Die Sauerstoff-Konzentration darf die obere Grenze von $5,85 \times 10^{17}$ Atome/cm$^3$ auch nicht überschreiten, weil BMD-Keime sonst zu groß werden und die Halbleiterscheibe dazu neigt, nach dem Abscheiden einer epitaktischen Schicht auf der Halbleiterscheibe Zwillingsversetzungen auf der Oberfläche der epitaktischen Schicht zu bilden. Vorzugsweise ist die Sauerstoff-Konzentration nicht größer als $5,7 \times 10^{17}$ Atome/cm$^3$.

Ist die Stickstoff-Konzentration niedriger, als die untere Grenze von $5 \times 10^{12}$ Atome/cm$^3$, führt das zu den gleichen Nachteilen wie beim Unterschreiten der unteren Grenze der Sauerstoff-Konzentration. Die obere Grenze der Stickstoff-Konzentration von $1,0 \times 10^{14}$ Atome/cm$^3$ darf nicht überschritten werden, weil die Halbleiterscheibe sonst nach dem Abscheiden einer epitaktischen Schicht auf der Halbleiterscheibe und nach einer Wärmebehandlung, die BMD-Keime zu BMDs wachsen lässt, BMDs aufweist, deren Dichte überhöht ist. Eine Überhöhung der Dichte von BMDs liegt vor, wenn die Dichte entlang des Radius der Halbleiterscheibe eine obere Grenze von $2,5 \times 10^9$ /cm$^3$ stellenweise oder vollständig überschreitet. Vorzugsweise ist die Stickstoff-Konzentration nicht größer als $3,5 \times 10^{13}$ Atome/cm$^3$.

Die Gegenwart von Wasserstoff unterdrückt die Bildung von Keimen von OSF-Defekten und trägt zu einer Vergleichmäßigung des radialen Verlaufs der Dichte von BMDs bei, insbesondere im Randbereich der Halbleiterscheibe. Die Wasserstoff-Konzentration in der Halbleiterscheibe beträgt deshalb nicht weniger als $3 \times 10^{13}$ Atome/cm$^3$. Ist die Wasserstoff-Konzentration kleiner als die untere Grenze, wird der radiale Verlauf der Dichte von BMDs im Randbereich der Halbleiterscheibe zu inhomogen. Ist die Wasserstoff-Konzentration größer als die obere Grenze von $8 \times 10^{13}$ Atome/cm$^3$, neigt die Halbleiterscheibe dazu, nach dem Abscheiden einer epitaktischen Schicht Zwillingsversetzungen auf der epitaktischen Schicht zu bilden. Aus diesem Grund wird der Einkristall aus Silizium, von dem die Halbleiterscheibe abgetrennt wird, in einer Atmosphäre gezogen, die Wasserstoff enthält, wobei der Partialdruck des Wasserstoffs nicht weniger als 5 Pa und nicht mehr als 15 Pa beträgt.

Das Beachten der genannten Konzentrations-Bereiche bezüglich Sauerstoff, Stickstoff und Wasserstoff genügt für sich genommen noch nicht, um die Aufgabe zu lösen. Zusätzlich müssen noch drei weitere Eigenschaften erfüllt sein: Die entlang des Radius der Halbleiterscheibe gemittelte Dichte von BMD-Keimen, bestimmt durch IR-Tomographie, beträgt nicht weniger als $1 \times 10^5$ cm$^3$ und nicht mehr als $1 \times 10^7$ cm$^{-3}$.

Die entlang des Radius der Halbleiterscheibe bestimmte mittlere Dichte von Oberflächendefekten beträgt nicht weniger als 1100 cm$^{-2}$, vorzugsweise bis zu 10000 cm$^{-2}$, bestimmt durch optische Mikroskopie nach einer ersten Wärmebehandlung der Halbleiterscheibe bei einer Temperatur von 900 °C über einen Zeitraum von 8 h in einer Atmosphäre von Stickstoff und einer zweiten Wärmebehandlung bei einer Temperatur von 1100 °C über einen Zeitraum von 2 h in einer Atmosphäre von Sauerstoff und Wasserstoff. Fällt die mittlere Dichte von Oberflächendefekten unter den Wert von 1100 cm$^{-2}$, ist das ein Hinweis auf eine inhomogene Verteilung von BMD-Keimen.

Die Dichte von BMDs liegt nicht unter einer unteren Grenze von $5 \times 10^8$ /cm$^3$, wenn sie entlang des Radius R der Halbleiterscheibe von einer radialen Position r = R/3 bis zu einer radialen Position r = R/1,15 durch IR-Tomographie nach Wärmebehandlungen der Halbleiterscheibe bei einer Temperatur von 780 °C über einen Zeitraum von 3 h und bei einer Temperatur von 1000 °C über einen Zeitraum von 16 h bestimmt wird.

Um eine Halbleiterscheibe mit den genannten Eigenschaften zu erhalten, muss diese von einem Einkristall stammen, der unter bestimmten Bedingungen gezogen wurde. Beim Ziehen des Einkristalls muss der Quotient V/G in engen Grenzen bleiben, innerhalb derer der Einkristall im $P_v$-Gebiet mit passendem Überschuss an Leerstellen kristallisiert. Vorzugsweise wird vom Zentrum des Einkristalls bis zu dessen Rand über eine radiale Länge von nicht weniger als 98 % des Radius des Einkristalls $P_v$-Gebiet mit passendem Überschuss an Leerstellen gebildet. Das Entstehen von $P_v$-Gebiet mit einem vergleichsweise geringen Überschuss an Leerstellen muss ausgeschlossen sein, weil in diesem Fall zu wenige BMD-Keime gebildet werden, deren Größe ausreicht, um das Abscheiden einer epitaktischen Schicht auf der Halbleiterscheibe zu überstehen. Der Überschuss an Leerstellen darf aber auch nicht zu groß sein und dessen radialer Verlauf nicht zu sehr schwanken. Das Prozessfenster für $P_v$-Gebiet darf also nicht vollständig ausgeschöpft werden.

Diese Anforderungen werden erfüllt, indem die Ziehgeschwindigkeit V kontrolliert wird, um den Quotienten V/G zu kontrollieren. Damit der Einkristall im $P_v$-Gebiet mit passendem Überschuss an Leerstellen wächst, wird die Ziehgeschwindigkeit V mit der Maßgabe kontrolliert, dass sie nicht jeden Wert einer Spanne $\Delta V$ von Ziehgeschwindigkeiten annehmen darf, der das Wachsen des Einkristalls im $P_v$-Gebiet gewährleistet. Die zulässige Ziehgeschwindigkeit liegt in einem Teilbereich der Spanne $\Delta V$, der 39 % von $\Delta V$ umfasst und dessen niedrigste Ziehgeschwindigkeit 26 % größer ist, als die Ziehgeschwindigkeit $V_{Pv/Pi}$ am Übergang von $P_v$-Gebiet zum $P_i$-Gebiet.

Die Ziehgeschwindigkeit $V_{Pv/Pi}$ und die Spanne $\Delta V$ werden experimentell bestimmt, beispielsweise indem ein Test-Einkristall mit linear steigendem oder fallendem Verlauf der Ziehgeschwindigkeit gezogen wird. Dabei wird dieselbe hot zone verwendet, die zum Ziehen eines Einkristalls gemäß der Erfindung vorgesehen ist. Jeder axialen Position im Test-Einkristall ist eine Ziehgeschwindigkeit zugeordnet. Der Test-Einkristall wird axial geschnitten und beispielsweise mittels Dekoration mit Kupfer oder mittels Messung der Lebensdauer von Minoritäts-Ladungsträgern auf Punktdefekte untersucht. Die Spanne $\Delta V$ erstreckt sich von der niedrigsten Ziehgeschwindigkeit bis zur höchsten Ziehgeschwindigkeit, bei der vom Zentrum bis zum Rand des Test-Einkristalls über eine radiale Länge von nicht weniger als 98 % des Radius des Test-Einkristalls $P_v$-Gebiet nachgewiesen werden kann. Die in diesem Sinn niedrigste Ziehgeschwindigkeit ist die Ziehgeschwindigkeit $V_{Pv/Pi}$.

Vorzugsweise wird die Ziehgeschwindigkeit V im gesamten Abschnitt des Einkristalls mit einheitlichem Durchmesser auf die genannte Weise kontrolliert, damit alle Halbleiterscheiben, die von diesem Abschnitt geschnitten werden, die vorgesehenen Eigenschaften haben. Der Durchmesser des Einkristalls in diesem Abschnitt und der Durchmesser der resultierenden Halbleiterscheiben beträgt vorzugsweise nicht weniger als 200 mm, besonders bevorzugt nicht weniger als 300 mm.

Um zu unterstützen, dass ein möglichst großer Anteil dieses Abschnitts des Einkristalls über eine radiale Länge von nicht weniger als 98 % des Radius im $P_v$-Gebiet mit passendem Überschuss an Leerstellen wächst, ist es vorteilhaft, zum Ziehen des Einkristalls eine hot zone zu verwenden, aufgrund derer der axiale Temperaturgradient $G_c$ im Zentrum der Kristallisationsgrenze in einem Temperaturbereich vom Schmelzpunkt bis 1370 °C größer ist, als der entsprechende Temperaturgradient $G_e$ am Rand der Kristallisationsgrenze. Vorzugsweise gilt:

$1 < G_c/G_e \leq 1{,}15$

Des Weiteren ist es von Vorteil, den Einkristall zu kühlen, um die Bildung von Defekten zu behindern, beispielsweise die Bildung von Keimen von OSF-Defekten. Vorzugsweise werden folgende Abkühlraten nicht unterschritten:

1,7 °C/min im Temperaturbereich von 1250 bis 1000 °C;

1,2 °C/min im Temperaturbereich von unter 1000 bis 800 °C; und 0,4 °C/min im Temperaturbereich von unter 800 bis 500 °C.

Zu beachten ist, dass auf Grund von Segregation die Konzentration von Stickstoff im Einkristall vom Anfang bis zum Ende des Einkristalls zunimmt. Um eine möglichst hohe Ausbeute an erfindungsgemäßen Halbleiterscheiben zu erhalten, ist es vorteilhaft, den axialen Verlauf der Konzentrationen von Sauerstoff und Stickstoff im Einkristall gegenläufig abzustimmen. So sollte der Einbau von Sauerstoff in den Einkristall so kontrolliert werden, dass der anfänglich vergleichsweise niedrigen Konzentration von Stickstoff eine vergleichsweise hohe Konzentration von Sauerstoff gegenübersteht und die Konzentration von Sauerstoff mit der Zunahme der Konzentration von Stickstoff abnimmt. Vorzugsweise beträgt die Konzentration von Sauerstoff im Abschnitt des Einkristalls mit einheitlichem Durchmesser an einer Position, die 50 mm vom Anfang dieses Abschnitts des Einkristalls liegt, nicht weniger als $5,4 \times 10^{17}$ Atome/cm$^3$.

Bevorzugt ist auch, die Konzentration von Wasserstoff am Anfang des Abschnitts des Einkristalls mit einheitlichem Durchmesser niedriger einzustellen, als am Ende dieses Abschnitts. Besonders bevorzugt ist es, den Partialdruck des Wasserstoffs in der Atmosphäre, in der der Einkristall gezogen wird, derart einzustellen, dass er am Anfang des Abschnitts des Einkristalls mit einheitlichem Durchmesser im Bereich der unteren Grenze von 5 Pa und am Ende dieses Abschnitts im Bereich der oberen Grenze von 15 Pa liegt. Beispielsweise wird der Partialdruck des Wasserstoffs im Fall eines Einkristalls aus Silizium mit einem Durchmesser von mindestens 300 mm und einer Gesamtlänge des Abschnitts mit gleichbleibendem Durchmesser von mindestens 2200 mm bis zur Hälfte der Gesamtlänge des Abschnitts des Einkristalls mit einheitlichem Durchmesser auf nicht weniger als 5 Pa und nicht mehr als 7 Pa eingestellt, anschließend linear angehoben bis hinsichtlich des Partialdrucks des Wasserstoffs nicht weniger als 12 Pa und nicht mehr als 15 Pa und hinsichtlich der Länge dieses Abschnitts des Einkristalls 55 bis 60 % von dessen Gesamtlänge erreicht sind, und der Partialdruck des Wasserstoffs beibehalten, bis der Abschnitt des Einkristalls mit einheitlichem Durchmesser die vorgesehene Gesamtlänge erreicht hat. Auf diese Weise wird insbesondere am Anfang des Abschnitts des Einkristalls mit einheitlichem Durchmesser eine Vergleichmäßigung der Dichte von BMDs im Randbereich der später resultierenden Halbleiterscheibe gesichert und vermieden, dass insbesondere am Ende dieses Abschnitts des Einkristalls, wenn die Konzentration an Stickstoff vergleichsweise hoch ist, Keime von OSF-Defekten entstehen. Die Beschränkung des Partialdrucks des Wasserstoffs auf die obere Grenze von 15 Pa reduziert darüber hinaus die Bildung größerer BMD-Keime, von denen nach dem Abscheiden einer epitaktischen Schicht auf der Halbleiterscheibe Zwillingsversetzungen ausgehen. Die Gegenwart von Zwillingsversetzungen macht sich durch eine erhöhte Anzahl sogenannter localized light scatterers (LLS) bemerkbar.

Eine erfindungsgemäße Halbleiterscheibe wird von einem Einkristall abgetrennt, der unter den geschilderten Bedingungen nach der Cz-Methode aus einer Schmelze gezogen wurde. Anschließend werden die obere und die untere Seitenfläche sowie die Kante der Halbleiterscheibe einem oder mehreren mechanischen Bearbeitungsschritten und mindestens einer Politur unterzogen. Auf der polierten oberen Seitenfläche der Halbleiterscheibe wird vorzugsweise eine epitaktische Schicht in an sich bekannter Weise abgeschieden. Die epitaktische Schicht besteht vorzugsweise aus einkristallinem Silizium und hat eine Dicke von vorzugsweise 2 μm bis 7 μm. Die Temperatur während des Abscheidens der epitaktischen Schicht beträgt vorzugsweise 1100 °C bis 1150 °C. Die Halbleiterscheibe und die epitaktische Schicht sind mit einem elektrisch aktiven Dotierstoff wie beispielsweise Bor dotiert, vorzugsweise entsprechend der Dotierung einer pp⁻- dotierten epitaktischen Halbleitescheibe.

Die Anzahl an Zwillingsversetzungen auf der Oberfläche der epitaktischen Schicht beträgt vorzugsweise weniger als 5.

Die durch das Abscheiden einer epitaktischen Schicht auf der Vorderseite der Halbleiterscheibe entstehende Halbleiterscheibe mit epitaktischer Schicht hat trotz des Abscheidens der epitaktischen Schicht das Potenzial, BMDs bilden zu können, deren Dichte ausreicht, um der Halbleiterscheibe die erforderliche Wirkung als interner Getter zu verleihen. Die Dichte von BMDs bleibt jedoch ausreichend niedrig und deren radialer Verlauf ausreichend homogen, so dass Probleme wegen Overlay-Defekten vermieden werden.

Die BMDs werden vorzugsweise im Zuge der Herstellung elektronischer Bauelemente in der epitaktischen Schicht und damit einhergehender Wärmebehandlungen gebildet. Sie können aber auch gebildet werden, indem die Halbleiterscheibe nach dem Abscheiden der epitaktischen Schicht und vor der Herstellung elektronischer Bauelemente einer oder mehrerer Wärmebehandlungen unterzogen wird.

Die Dichte von BMDs beträgt im Fall der Halbleiterscheibe mit epitaktischer Schicht nicht weniger als $3 \times 10^8$ /cm$^3$ und nicht mehr als $2,5 \times 10^9$ /cm$^3$, bestimmt vom Zentrum bis zum Rand der Halbleiterscheibe bei einem Randausschluss von 1 mm durch IR-Tomographie nach Wärmebehandlungen der Halbleiterscheibe mit epitaktischer Schicht bei einer Temperatur von 780 °C über einen Zeitraum von 3 h und bei einer Temperatur von 1000 °C über einen Zeitraum von 16 h.

Ein weiteres Qualitätsmerkmal der Halbleiterscheibe mit epitaktischer Schicht ist, dass die Dichte von BMDs um nicht mehr als 80 % bezogen auf eine mittlere Dichte variiert, wobei die Dichte von BMDs entlang des Radius R der Halbleiterscheibe mit epitaktischer Schicht von einer radialen Position r = R/1,0791 bis zu einer radialen Position r = R/1,0135 durch IR-Tomographie nach Wärmebehandlungen der Halbleiterscheibe mit epitaktischer Schicht bei einer Temperatur von 780 °C über einen Zeitraum von 3 h und bei einer Temperatur von 1000 °C über einen Zeitraum von 16 h bestimmt wird. Mit anderen Worten ausgedrückt, gilt:

$$(D_{BMDmax} - D_{BMDmin})/D_{BMDmean} \leq 0,8$$

wobei $D_{BMDmean}$ die entlang eines Randbereichs gemittelte Dichte von BMDs und $D_{BMDmax}$ und $D_{SMDmin}$ die größte und kleinste Dichte von BMDs innerhalb des Randbereichs bezeichnen und sich der Randbereich von der radialen Position r = R/1,0791 bis zur radialen Position r = R/1,0135 erstreckt.

Bestimmung der Wasserstoff-Konzentration:

Zur Bestimmung der Wasserstoff-Konzentration wird ein Messobjekt mit der Form eines quaderförmigen Blocks (3 cm x 3 cm x 30 cm) von einem Einkristall geschnitten. Nach einer Wärmebehandlung des Messobjekts bei einer Temperatur von 700 °C über einen Zeitraum von 5 min und schneller Abkühlung des Messobjekts wird die Wasserstoff-Konzentration mittels FTIR-Spektroskopie bei Raumtemperatur gemessen. Vor der FTIR-Messung wird ein Teil des Wasserstoffs, der sonst der Messung entzogen wäre, mittels Bestrahlung des Messobjekts mit Gammastrahlen einer $Co^{60}$-Quelle aktiviert. Die Energiedosis der Bestrahlung beträgt 5000 bis 21000 kGy. Eine Messkampagne umfasst 1000 Abtastungen mit einer Auflösung von 1 $cm^{-1}$ je Messobjekt. Ausgewertet werden Schwingungsbanden bei Wellenzahlen von 1832, 1916, 1922, 1935, 1951, 1981, 2054, 2100, 2120 und 2143 $cm^{-1}$. Die Konzentration an Wasserstoff errechnet sich aus der Summe der integrierten Adsorptionskoeffizienten der jeweiligen Schwingungsbanden multipliziert mit dem Umrechnungsfaktor 4,413 x $10^{16}$ $cm^{-1}$. Ist die Wasserstoff-Konzentration einer Halbleiterscheibe zu messen, wird auf die Wärmebehandlung des Messobjekts bei einer Temperatur von 700 °C verzichtet und als Messobjekt ein Streifen mit einer Fläche von 3 cm x 20 cm verwendet, der von der Halbleiterscheibe geschnitten wird.

Messung der Dichte von BMD-Keimen mittels IR-Tomographie:

Die Messung der Dichte von BMD-Keimen mittels IR-Tomographie (infrared laser scattering tomography) erfolgt entlang einer radialen Bruchkante einer Halbleiterscheibe, deren Kristallgitter im gewachsenen Zustand (as grown) ist. In diesem Zustand hat die Halbleiterscheibe keine Wärmebehandlung erfahren, die BMD-Keime löscht oder zu BMDs entwickelt. Die Messmethode an sich ist bekannt (Kazuo Moriya et al., J. Appl.Phys. 66, 5267 (1989)). Hier angegebene experimentell bestimmte Dichten von BMD-Keimen wurden mit einem Messgerät vom Typ BMD-Analyzer MO-441 der Raytex Corporation ermittelt.

Messung der Dichte von BMDs mittels IR-Tomographie:

Die Halbleiterscheibe beziehungsweise die Halbleiterscheibe mit epitaktischer Schicht wird vor der Messung Wärmebehandlungen bei einer Temperatur von 780 °C über einen Zeitraum von 3 h und bei einer Temperatur von 1000 °C über einen Zeitraum von 16 h unterzogen. Die Messung der Dichte von BMDs erfolgt danach auf die gleiche Weise wie im Fall der Messung der Dichte von BMD-Keimen.

Messung der Dichte von Oberflächendefekten mittels optischer Mikroskopie:

Die Halbleiterscheibe wird vor der Messung einer ersten Wärmebehandlung bei einer Temperatur von 900 °C über einen Zeitraum von 8 h in einer Atmosphäre von Stickstoff und anschließend einer zweiten Wärmebehandlung bei einer Temperatur von 1100 °C über einen Zeitraum von 2 h in einer Atmosphäre von Sauerstoff und Wasserstoff unterzogen. Eine Oxidschicht, die sich auf der Oberfläche bildet, wird nach den beiden Wärmebehandlungen mittels Fluorwasserstoff entfernt. Anschließend erfolgt eine dreiminütige Delineation von Oberflächendefekten mittels Secco-Ätze und das Zählen der Anzahl der Oberflächendefekte mittels optischer Mikroskopie auf der oberen Seitenfläche der Halbleiterscheibe entlang von deren Radius. Alle Oberflächendefekte, deren längste Diagonale größer als 5 μm ist, werden mitgezählt.

Die Erfindung wird nachfolgend unter Bezugnahme auf Figuren weiter erläutert.

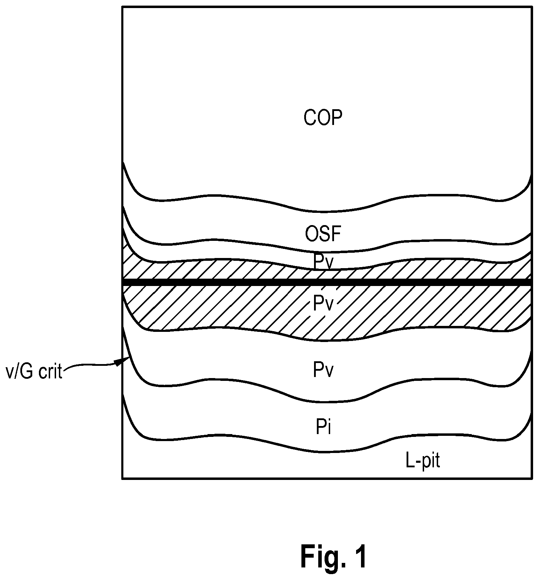

Fig.1 zeigt, wie sich die Materialbeschaffenheit eines Einkristalls aus Silizium von einem, von Leerstellen dominierten Gebiet zu einem, von Silizium-Zwischengitteratomen dominierten Gebiet in Abhängigkeit des Quotienten V/G ändert, wenn der Quotient V/G während des Ziehens des Einkristalls nach der CZ-Methode geändert wird. Dargestellt ist ein Axialschnitt durch einen Abschnitt mit konstantem Durchmesser eines solchen Einkristalls. Der Quotient V/G fällt von oben nach unten und schwankt entlang des Durchmessers, also von links nach rechts. Von Leerstellen dominiert sind die Gebiete COP, OSF und Pv. Die Gebiete Pi und L-pit sind von Silizium-Zwischengitteratomen dominiert. Der Quotient v/$G_{crit}$ bezeichnet den Quotienten V/G am Übergang von Pv-Gebiet zu Pi-Gebiet. Das Pv-Gebiet ist untergliedert in eine obere, mittlere und untere Domäne. Eine erfindungsgemäße Halbleiterscheibe besteht aus Material der schraffiert dargestellten, mittleren Domäne und ist als horizontale Linie in dieser Domäne symbolisiert. Eine Halbleiterscheibe, die aus Material der oberen oder der unteren Domäne des Pv-Gebiets besteht, ist nicht erfindungsgemäß, weil damit insbesondere die geforderte radiale Homogenität der BMD-Dichte nicht zu erreichen ist.

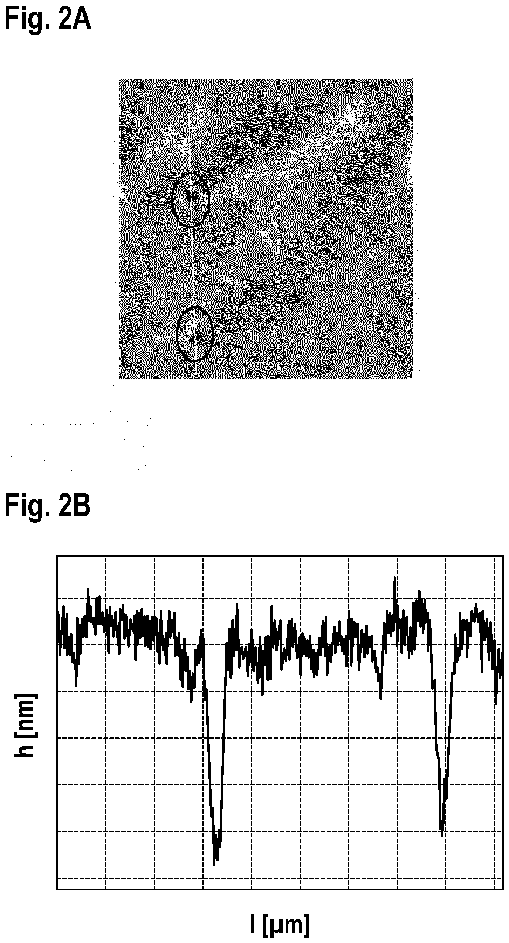

Fig.2A zeigt eine typische Zwillingsversetzung auf einer AFM-Aufnahme von einem Messfeld mit einer Fläche von 10 $\mu$m x 10 $\mu$m Fläche. Fig.2B zeigt das dazugehörende Höhenprofil (relative Höhe h) entlang der in Fig.2A zu sehenden hellen Linie (Länge I).

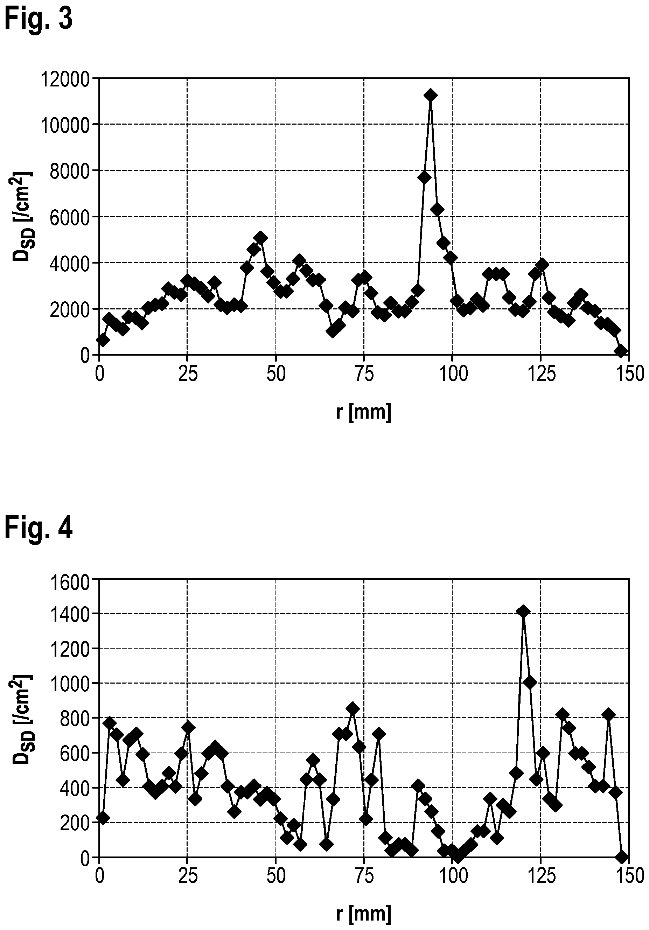

Fig.3 zeigt den radialen Verlauf der Dichte von Oberflächendefekten $D_{SD}$ am Beispiel einer erfindungsgemäß hergestellten Halbleiterscheibe aus einkristallinem Silizium mit einem Durchmesser von 300 mm. Die über den Radius R der Halbleiterscheibe gemittelte Dichte $D_{SD}$ liegt über dem geforderten Wert von 1100 /cm$^2$. Der Radius R erstreckt sich von einer radialen Position r im Zentrum der Halbleiterscheibe (r=0) bis zu einer radialen Position r am Rand der Halbleiterscheibe (r=R).

Zum Vergleich dazu zeigt Fig.4 den radialen Verlauf der Dichte von Oberflächendefekten $D_{SD}$ am Beispiel einer nicht erfindungsgemäß hergestellten Halbleiterscheibe aus einkristallinem Silizium mit einem Durchmesser von 300 mm. Die über den Radius R der Halbleiterscheibe gemittelte Dichte $D_{SD}$ liegt unter dem geforderten Wert von 1100 /cm$^2$.

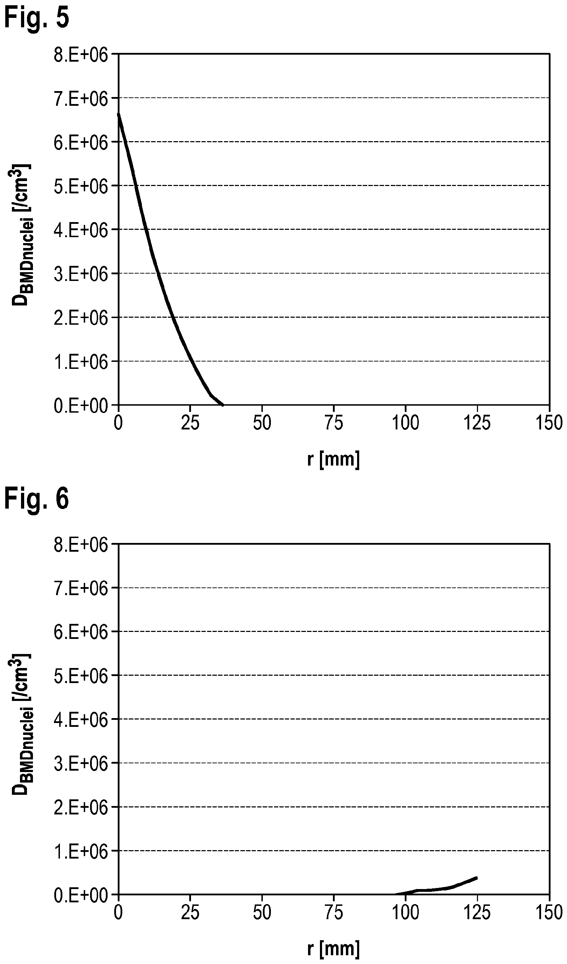

Fig.5 zeigt den radialen Verlauf der Dichte von BMD-Keimen $D_{BMDnuclei}$ am Beispiel einer erfindungsgemäß hergestellten Halbleiterscheibe aus einkristallinem Silizium mit einem Durchmesser von 300 mm. Die über den Radius R der Halbleiterscheibe gemittelte Dichte $D_{BMDnuclei}$ liegt im geforderten Bereich von nicht weniger als 1 x 10$^5$ cm$^{-3}$ und nicht mehr als 1 x 10$^7$ cm$^{-3}$.

Zum Vergleich dazu zeigt Fig.6 den radialen Verlauf der Dichte von BMD-Keimen $D_{BMDnuclei}$ am Beispiel einer nicht erfindungsgemäß hergestellten Halbleiterscheibe aus einkristallinem Silizium mit einem Durchmesser von 300 mm. Die über den Radius R der Halbleiterscheibe gemittelte Dichte $D_{BMDnuclei}$ liegt nicht im geforderten Bereich von nicht weniger als 1 x 10$^5$ cm$^3$ und nicht mehr als 1 x 10$^7$ cm$^{-3}$.

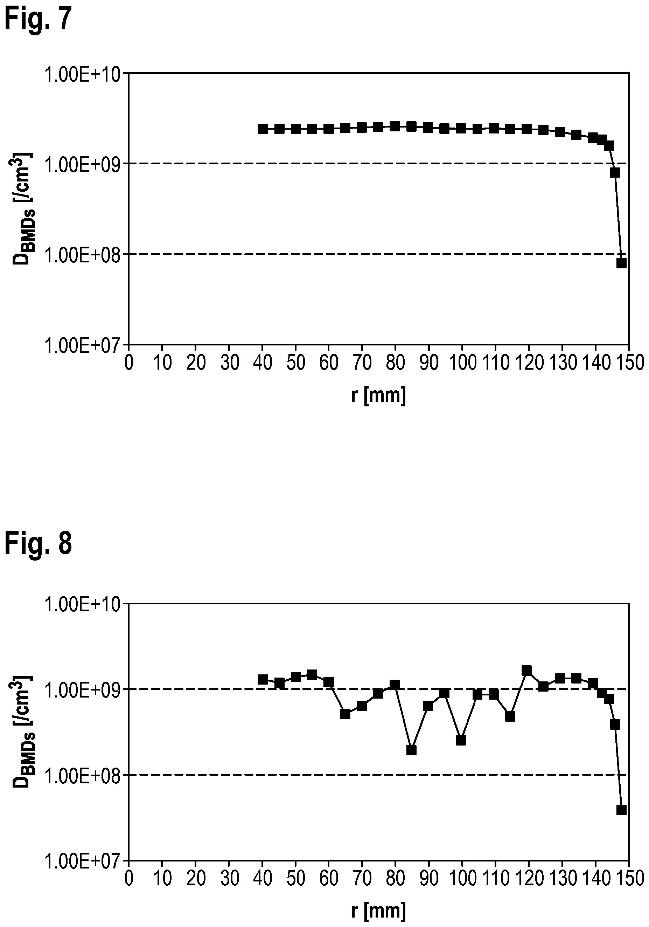

Fig.7 zeigt den radialen Verlauf der Dichte von BMDs $D_{BMDs}$ von einer radialen Position r = R/3 bis zum Radius R der Halbleiterscheibe am Beispiel einer erfindungsgemäß hergestellten Halbleiterscheibe aus einkristallinem Silizium mit einem Durchmesser von 300 mm. Beim Ziehen des Einkristalls lag der Partialdruck von Wasserstoff mit 12 Pa im geforderten Bereich. Das Minimum der Dichte von BMDs $D_{BMDs}$ im Bereich von r = R/3 bis r = R/1,15 liegt über der geforderten unteren Grenze von 5 x 10$^8$ /cm$^3$.

Zum Vergleich dazu zeigt Fig.8 den radialen Verlauf der Dichte von BMDs $D_{BMDs}$ von einer radialen Position r = R/3 bis zum Radius R der Halbleiterscheibe am Beispiel einer nicht erfindungsgemäß hergestellten Halbleiterscheibe aus einkristallinem Silizium mit einem Durchmesser von 300 mm. Beim Ziehen des Einkristalls war der Partialdruck von Wasserstoff mit unter 5 Pa kleiner als gefordert. Das Minimum der Dichte von BMDs $D_{BMDs}$ im Bereich von r = R/3 bis r = R/1,15 liegt unter der geforderten unteren Grenze von 5 x 10$^8$ /cm$^3$.

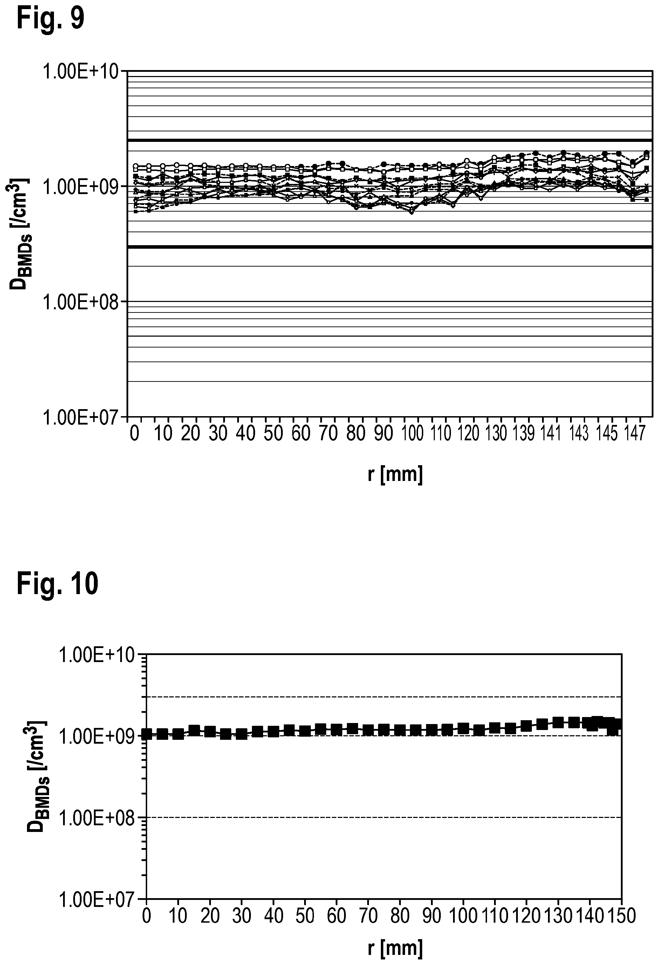

Fig.9 zeigt den radialen Verlauf der Dichte von BMDs $D_{BMDs}$ entlang des Radius R der Halbleiterscheibe am Beispiel erfindungsgemäß hergestellter Halbleiterscheiben aus einkristallinem Silizium mit einem Durchmesser von 300 mm und mit einer auf der Vorderseite der jeweiligen Halbleiterscheibe abgeschiedenen epitaktischen Schicht aus Silizium. Unabhängig von der axialen Position der jeweiligen Halbleiterscheibe im Einkristall ist der radiale Verlauf der Dichte von BMDs vergleichsweise homogen. Die Dichte von BMDs bewegt sich in allen Fällen innerhalb eines Bereichs von nicht weniger als 3 x 10$^8$ /cm$^3$ und nicht mehr als 2,5 x 10$^9$ /cm$^3$.

Die nachfolgende Tabelle enthält Daten zu Halbleiterscheiben aus einkristallinem Silizium mit erfindungsgemäßen Eigenschaften (Beispiel B1 bis B3) und solchen, die wegen Nichterfüllens einer oder mehrerer Anforderungen (Vergleichsbeispiel V1 bis V4) nicht zu den erfindungsgemäßen Halbleiterscheiben zählen.

Tabelle:

| | BMD-Keime[1] [/cm$^3$] | Oberflächendefekte[2] [/cm$^2$] | BMD-Dichte [/cm$^3$] | Position[3] [mm] |
|---|---|---|---|---|
| B1 | 1,19 x 10$^6$ | 2974 | 2,22 x 10$^9$ | 72 |

(fortgesetzt)

|  | BMD-Keime[1] [/cm³] | Oberflächendefekte[2] [/cm²] | BMD-Dichte [/cm³] | Position[3] [mm] |
|---|---|---|---|---|
| B2 | $1,21 \times 10^6$ | 1430 | $1,11 \times 10^9$ | 57 |
| B3 | $2,99 \times 10^5$ | 2208 | $2,17 \times 10^9$ | 62 |
| V1 | $2,15 \times 10^6$ | 962 | $3,90 \times 10^9$ | 87 |
| V2 | $4,81 \times 10^4$ | 4130 | $4,88 \times 10^9$ | 97 |
| V3 | $1,60 \times 10^4$ | 879 | $3,21 \times 10^8$ | 85 |
| V4 | $1,93 \times 10^7$ | 1419 | $7,22 \times 10^8$ | 77 |

[1] über den Radius der Halbleiterscheibe gemittelte Dichte der BMD-Keime;
[2] über den Radius gemittelte Dichte der Oberflächendefekte;
[3] radiale Position des Minimums der BMD-Dichte.

Im Gegensatz zu den Halbleiterscheiben gemäß der Beispiele B1 bis B3 verfehlten die Halbleiterscheiben gemäß der Vergleichsbeispiele V1 bis V4 eine oder mehrere der Anforderungen bezüglich der Dichte der BMD-Keime, der Dichte der Oberflächendefekte und der BMD-Dichte. Nach dem Abscheiden einer epitaktischen Schicht aus Silizium hatten nur die Halbleiterscheiben mit epitaktischer Schicht auf Basis der Halbleiterscheiben der Vergleichsbeispiele Defizite, entweder wegen unzureichenden Potenzials des internen Getters oder wegen der Präsenz von Overlay-Defekten oder wegen einer größeren Anzahl von Zwillingsversetzungen.

Die Halbleiterscheiben mit epitaktischer Schicht, die aus den Halbleiterscheiben gemäß den Beispielen B1 bis B3 hervorgegangen waren, hatten solche Defizite nicht. Fig.10 zeigt den homogenen radialen Verlauf der BMD-Dichte der Halbleiterscheibe mit epitaktischer Schicht, die aus der Halbleiterscheibe gemäß Beispiel B3 hervorgegangen war.

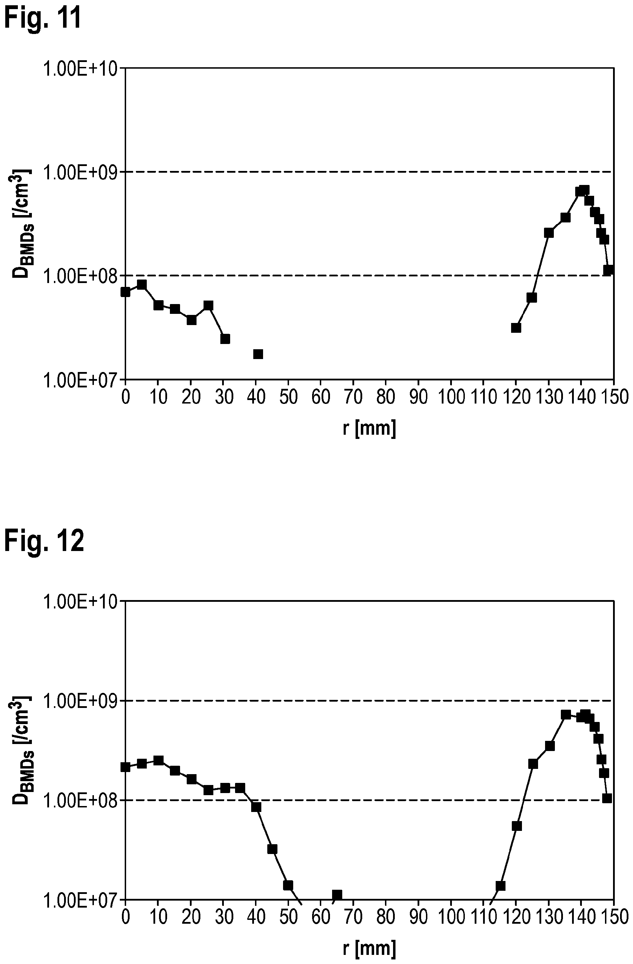

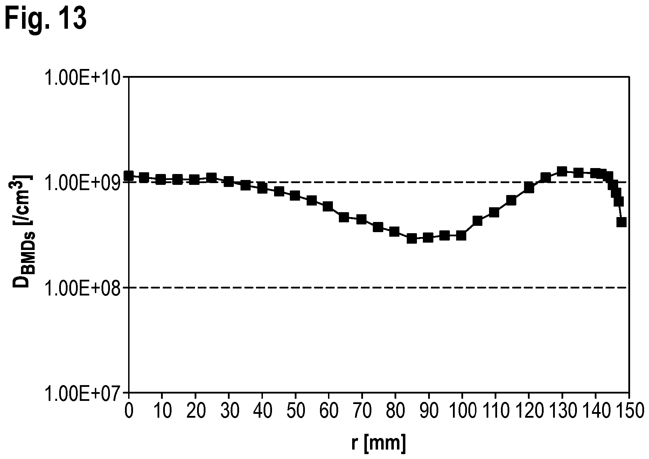

Die Fig.11 bis 13 zeigen, dass es vorteilhaft ist, zumindest während des Ziehens der zweiten Hälfte des Abschnitts des Einkristalls mit konstantem Durchmesser einen vergleichsweise hohen Partialdruck von Wasserstoff anzuwenden. Bestimmt wurde die BMD-Dichte von drei Halbleiterscheiben aus einkristallinem Silizium mit einem Durchmesser von 300 mm nach dem Abscheiden einer epitaktischen Schicht. Die jeweiligen Halbleiterscheiben wurden an bestimmten axialen Positionen der zweiten Hälfte des Abschnitts mit konstantem Durchmesser vom Einkristall geschnitten, wobei beim Ziehen des Einkristalls der Partialdruck von Wasserstoff an den jeweiligen Positionen unterschiedlich war. Der Wasserstoff-Partialdruck betrug an Position 622 mm 0 Pa, an Position 685 mm 5 Pa und an Position 761 mm 12 Pa. Der Vergleich von Fig.11 (Position 622 mm), Fig.12 (Position 685 mm) und Fig.13 (Position 761 mm) zeigt, dass die BMD-Dichte der entsprechenden Halbleiterscheibe mit epitaktischer Schicht nur im Fall der Halbleiterscheibe an Position 761 mm einen angestrebten radial homogenen Verlauf mit angestrebten Werten hatte.

**Patentansprüche**

1. Halbleiterscheibe aus einkristallinem Silizium mit einem Zentrum, einem Rand und einem Radius R zwischen dem Zentrum und dem Rand, wobei die Halbleiterscheibe aufweist:

eine Sauerstoff-Konzentration von nicht weniger als $4,9 \times 10^{17}$ Atome/cm³ und nicht mehr als $5,85 \times 10^{17}$ Atome/cm³;
eine Stickstoff-Konzentration von nicht weniger als $5 \times 10^{12}$ Atome/cm³ und nicht mehr als $1,0 \times 10^{14}$ Atome/cm³;
eine Wasserstoff-Konzentration von nicht weniger als $3 \times 10^{13}$ Atome/cm³ und nicht mehr als $8 \times 10^{13}$ Atome/cm³;
BMD-Keime, deren über den Radius der Halbleiterscheibe gemittelte Dichte, bestimmt durch IR-Tomographie, nicht weniger als $1 \times 10^5$ cm⁻³ und nicht mehr als $1 \times 10^7$ cm⁻³ beträgt;
Oberflächendefekte, deren längste Diagonale größer als 5 μm ist und deren über den Radius gemittelte Dichte nicht weniger als 1100 cm⁻² beträgt, bestimmt durch optische Mikroskopie nach Wärmebehandlungen der Halbleiterscheibe bei einer Temperatur von 900 °C über einen Zeitraum von 8 h in einer Atmosphäre von Stickstoff und bei einer Temperatur von 1100 °C über einen Zeitraum von 2 h in einer Atmosphäre von Sauerstoff und Wasserstoff; und
BMDs, deren Dichte nicht unter einer unteren Grenze von $5 \times 10^8$ /cm³ liegt, bestimmt entlang des Radius von einer radialen Position r = R/3 bis zu einer radialen Position r = R/1,15 durch IR-Tomographie nach Wärmebehandlungen der Halbleiterscheibe bei einer Temperatur von 780 °C über einen Zeitraum von 3 h und bei einer Temperatur von 1000 °C über einen Zeitraum von 16 h, wobei die Wasserstoff-Konzentration, die gemittelte Dichte der BMD-Keime, die gemittelte Dichte der Oberflächendefekte und die Dichte der BMDs durch die in der Beschreibung angegebenen Messmethoden bestimmt werden.

**2.** Halbleiterscheibe nach Anspruch 1, **dadurch gekennzeichnet, dass** eine Vorderseite der Halbleiterscheibe mit einer epitaktischen Schicht aus Silizium bedeckt ist.

**3.** Halbleiterscheibe nach Anspruch 2, **dadurch gekennzeichnet, dass** die Dichte von BMDs nicht weniger als 3 x $10^8$ /cm$^3$ und nicht mehr als 5 x $10^9$ /cm$^3$ ist, bestimmt vom Zentrum bis zum Rand der Halbleiterscheibe bei einem Randausschluss von 1 mm und ausgewertet durch IR-Tomographie nach Wärmebehandlungen der Halbleiterscheibe bei einer Temperatur von 780 °C über einen Zeitraum von 3 h und bei einer Temperatur von 1000 °C über einen Zeitraum von 16 h.

**4.** Halbleiterscheibe nach Anspruch 2 oder Anspruch 3, **dadurch gekennzeichnet, dass** die Dichte von BMDs um nicht mehr als 80 % bezogen auf eine gemittelte Dichte variiert, bestimmt entlang des Radius von einer radialen Position r = R/1,0791 bis zu einer radialen Position r = R/1,0135 und ausgewertet durch IR-Tomographie nach Wärmebehandlungen der Halbleiterscheibe bei einer Temperatur von 780 °C über einen Zeitraum von 3 h und bei einer Temperatur von 1000 °C über einen Zeitraum von 16 h.

**5.** Verfahren zur Herstellung einer Halbleiterscheibe aus einkristallinem Silizium, umfassend

das Ziehen eines Einkristalls aus einer Schmelze gemäß der CZ-Methode mit einer Ziehgeschwindigkeit V, wobei die Schmelze mit Sauerstoff, Stickstoff und Wasserstoff dotiert wird und der Einkristall an einer Kristallisationsgrenze wächst;

das Ziehen des Einkristalls in einer Atmosphäre, die Wasserstoff enthält, wobei der Partialdruck des Wasserstoffs nicht weniger als 5 Pa und nicht mehr als 15 Pa beträgt;

das Kontrollieren des Einbaus von Sauerstoff, Stickstoff und Wasserstoff in einem Abschnitt des Einkristalls mit einheitlichem Durchmesser derart, dass die Sauerstoff-Konzentration nicht weniger als 4,9 x $10^{17}$ Atome/cm$^3$ und nicht mehr als 5,85 x $10^{17}$ Atome/cm$^3$, die Stickstoff-Konzentration nicht weniger als 5 x $10^{12}$ Atome/cm$^3$ und nicht mehr als 1,0 x $10^{14}$ Atome/cm$^3$ und die Wasserstoff-Konzentration nicht weniger als 3 x $10^{13}$ Atome/cm$^3$ und nicht mehr als 8 x $10^{13}$ Atome/cm$^3$ betragen;

das Kontrollieren der Ziehgeschwindigkeit V derart, dass sie innerhalb einer Spanne $\Delta V$ liegt, innerhalb derer der Einkristall im Abschnitt mit einheitlichem Durchmesser in einem $P_v$-Gebiet wächst, wobei die Ziehgeschwindigkeit V in einem Teilbereich der Spanne liegt, der 39 % der Spanne umfasst und eine niedrigste Ziehgeschwindigkeit des Teilbereichs 26 % größer ist, als eine Ziehgeschwindigkeit $V_{Pv/Pi}$ am Übergang vom $P_v$-Gebiet zu einem $P_i$-Gebiet; und

das Abtrennen der Halbleiterscheibe vom Abschnitt des Einkristalls mit einheitlichem Durchmesser, wobei die Spanne $\Delta V$ durch die in der Beschreibung angegebene Messmethode bestimmt wird.

**6.** Verfahren nach Anspruch 5, umfassend das Erhöhen des Partialdrucks des Wasserstoffs nachdem der Abschnitt des Einkristalls mit einheitlichem Durchmesser eine axiale Länge erreicht hat, die größer ist als 50 % einer vorgesehenen axialen Länge dieses Abschnitts.

**7.** Verfahren nach Anspruch 5 oder Anspruch 6, **dadurch gekennzeichnet, dass** auf einer Vorderseite der Halbleiterscheibe eine epitaktische Schicht aus Silizium abgeschieden wird.

**8.** Verfahren nach Anspruch 7, **dadurch gekennzeichnet, dass** vor dem Abscheiden der epitaktischen Schicht darauf verzichtet wird, den Einkristall oder die Halbleiterscheibe einer Wärmebehandlung zu unterziehen, die BMD-Keime durch Stabilisieren davor bewahrt, beim Abscheiden der epitaktischen Schicht aufgelöst werden.

**Claims**

**1.** A semiconductor wafer of monocrystalline silicon having a center, an edge and a radius R between the center and the edge, the semiconductor wafer comprising

an oxygen concentration of not less than 4.9 x $10^{17}$ atoms/cm$^3$ and not more than 5.85 x $10^{17}$ atoms/cm$^3$;

a nitrogen concentration of not less than 5 x $10^{12}$ atoms/cm$^3$ and not more than 1.0 x $10^{14}$ atoms/cm$^3$;

a hydrogen concentration of not less than 3 x $10^{13}$ atoms/cm$^3$ and not more than 8 x $10^{13}$ atoms/cm$^3$;

BMD nuclei whose density averaged over the radius of the wafer, as determined by IR tomography, is not less than 1 x $10^5$ cm$^{-3}$ and not more than 1 x $10^7$ cm$^{-3}$;

Surface defects whose longest diagonal is greater than 5 $\mu$m and whose density averaged over the radius is not less than 1100 cm$^{-2}$ as determined by optical microscopy after heat treatments of the semiconductor wafer at a temperature of 900 °C for a period of 8 h in an atmosphere of nitrogen and at a temperature of 1100 °C for a period of 2 h in an atmosphere of oxygen and hydrogen; and

BMDs whose density is not less than a lower limit of 5 x 10$^8$ /cm$^3$, determined along the radius from a radial position r = R/3 to a radial position r = R/1.15 by IR tomography after heat treatment of the semiconductor wafer at a temperature of 780 °C for a period of 3 h and at a temperature of 1000 °C for a period of 16 h where the hydrogen concentration, the average density of the BMD nuclei, the average density of the surface defects and the density of the BMDs are determined by the measuring methods specified in the description.

2. A semiconductor wafer according to claim 1, **characterized in that** a front side of the semiconductor wafer is covered with an epitaxial layer of silicon.

3. A semiconductor wafer according to claim 2, **characterized in that** the density of BMDs is not less than 3 x 10$^8$ /cm$^3$ and not more than 5 x 10$^9$ /cm$^3$, determined from the center to the edge of the semiconductor wafer at an edge exclusion of 1 mm and evaluated by IR tomography after heat treatments of the semiconductor wafer at a temperature of 780 °C for a period of 3 h and at a temperature of 1000 °C for a period of 16 h.

4. A semiconductor wafer according to claim 2 or claim 3, **characterized in that** the density of BMDs varies by not more than 80% based on an average density determined along the radius from a radial position r = R/1.0791 to a radial position r = R/1.0135 and evaluated by IR tomography after heat treatments of the semiconductor wafer at a temperature of 780°C for a period of 3 h and at a temperature of 1000°C for a period of 16 h.

5. A method for producing a semiconductor wafer of single-crystalline silicon, comprising pulling a single crystal from a melt according to the CZ method at a pulling speed V, whereby the melt is doped with oxygen, nitrogen and hydrogen and the single crystal grows at a crystallization boundary;

pulling the single crystal in an atmosphere containing hydrogen, wherein the partial pressure of the hydrogen is not less than 5 Pa and not more than 15 Pa;

controlling the incorporation of oxygen, nitrogen and hydrogen in a uniform diameter portion of the single crystal such that the oxygen concentration is not less than 4.9 x 10$^{17}$ atoms/cm$^3$ and not more than 5.85 x 10$^{17}$ atoms/cm$^3$, the nitrogen concentration is not less than 5 x 10$^{12}$ atoms/cm$^3$ and not more than 1.0 x 10$^{14}$ atoms/cm$^3$, and the hydrogen concentration is not less than 3 x 10$^{13}$ atoms/cm$^3$ and not more than 8 x 10$^{13}$ atoms/cm$^3$;

controlling the pulling speed V so as to be within a range $\Delta$V within which the single crystal grows in the uniform diameter portion in a Pv region, the pulling speed V being in a subregion of the range comprising 39% of the range and a lowest pulling speed of the subregion being 26% greater than a pulling speed $V_{Pv/Pi}$ at the transition from the Pv region to a Pi region; and

the separation of the semiconductor wafer from the section of the single crystal with uniform diameter, whereby the span $\Delta$V is determined by the measuring method specified in the description.

6. A method according to claim 5, comprising increasing the partial pressure of hydrogen after the uniform diameter portion of the single crystal has reached an axial length greater than 50% of an intended axial length of said portion.

7. A method according to claim 5 or claim 6, **characterized in that** an epitaxial layer of silicon is deposited on a front side of the semiconductor wafer.

8. A method according to claim 7, **characterized in that** before the epitaxial layer is deposited, the single crystal or the semiconductor wafer is not subjected to a heat treatment which prevents BMD nuclei from being dissolved during the deposition of the epitaxial layer by stabilizing them.

## Revendications

1. Une plaquette semi-conductrice en silicium monocristallin ayant un centre, un bord et un rayon R entre le centre et le bord, la plaquette semi-conductrice comprenant

une concentration en oxygène non inférieure à 4,9 x 10$^{17}$ atomes/cm$^3$ et non supérieure à 5,85 x 10$^{17}$ atomes/cm$^3$;

une concentration d'azote non inférieure à 5 x 10$^{12}$ atomes/cm$^3$ et non supérieure à 1,0 x 10$^{14}$ atomes/cm$^3$;

une concentration en hydrogène non inférieure à 3 x 10$^{13}$ atomes/cm$^3$ et non supérieure à 8 x 10$^{13}$ atomes/cm$^3$;

noyaux de BMD dont la densité moyenne sur le rayon de la plaquette, déterminée par tomographie IR, n'est pas

inférieure à $1 \times 10^5$ cm$^{-3}$ et pas supérieure à $1 \times 10^7$ cm$^{-3}$;

défauts de surface dont la diagonale la plus longue est supérieure à 5 $\mu$m et dont la densité moyenne sur le rayon n'est pas inférieure à 1100 cm$^{-2}$, déterminé par microscopie optique après traitement thermique de la plaquette semi-conductrice à une température de 900°C pendant une période de 8 h dans une atmosphère d'azote et à une température de 1100°C pendant une période de 2 h dans une atmosphère d'oxygène et d'hydrogène ; et

BMDs dont la densité n'est pas inférieure à une limite inférieure de $5 \times 10^8$ /cm$^3$, déterminée le long du rayon à partir d'une position radiale r = R/3 jusqu'à une position radiale r = R/1,15 par tomographie IR après traitement thermique de la plaquette semi-conductrice à une température de 780 °C pendant une période de 3 h et à une température de 1000 °C pendant une période de 16 h, où la concentration d'hydrogène, la densité moyenne des noyaux de BMD, la densité moyenne des défauts de surface et la densité des BMDs sont déterminées par les méthodes de mesure indiquées dans la description.

2. Plaquette de semi-conducteur selon la revendication 1, **caractérisée en ce qu'**une face avant de la plaquette de semi-conducteur est recouverte d'une couche épitaxiale de silicium.

3. Plaquette semi-conductrice selon la revendication 2, **caractérisée en ce que** la densité des BMDs n'est pas inférieure à $3 \times 10^8$ /cm$^3$ et pas supérieure à $5 \times 10^9$ /cm$^3$, déterminée du centre au bord de la plaquette semi-conductrice à une exclusion de bord de 1 mm et évaluée par tomographie IR après des traitements thermiques de la plaquette semi-conductrice à une température de 780°C pendant une période de 3 h et à une température de 1000°C pendant une période de 16 h.

4. Plaquette semi-conductrice selon la revendication 2 ou la revendication 3, **caractérisée en ce que** la densité des BMDs varie de 80% au maximum sur la base d'une densité moyenne, déterminée le long du rayon à partir d'une position radiale r = R/1,0791 jusqu'à une position radiale r = R/1,0135 et évaluée par tomographie IR après des traitements thermiques de la plaquette semi-conductrice à une température de 780°C pendant une période de 3 h et à une température de 1000°C pendant une période de 16 h.

5. Procédé de fabrication d'une plaquette semi-conductrice en silicium monocristallin, comprenant

le tirage d'un monocristal à partir d'une masse fondue selon la méthode CZ à une vitesse de tirage V, dans laquelle la masse fondue est dopée à l'oxygène, à l'azote et à l'hydrogène et le monocristal croît à une limite de cristallisation;

le tirage du monocristal dans une atmosphère contenant de l'hydrogène, dans laquelle la pression partielle de l'hydrogène n'est pas inférieure à 5 Pa et pas supérieure à 15 Pa;

contrôler l'incorporation de l'oxygène, de l'azote et de l'hydrogène dans une partie de diamètre uniforme du monocristal de telle sorte que la concentration en oxygène ne soit pas inférieure à $4,9 \times 10^{17}$ atomes/cm$^3$ et ne dépasse pas $5,85 \times 10^{17}$ atomes/cm$^3$, la concentration en azote ne soit pas inférieure à $5 \times 10^{12}$ atomes/cm$^3$ et ne dépasse pas $1,0 \times 10^{14}$ atomes/cm$^3$, et la concentration en hydrogène ne soit pas inférieure à $3 \times 10^{13}$ atomes/cm$^3$ et ne dépasse pas $8 \times 10^{13}$ atomes/cm$^3$;

contrôler la vitesse de tirage V de telle sorte qu'elle se situe dans une marge $\Delta$V dans laquelle le monocristal croît dans la section de diamètre uniforme dans une région Pv, dans laquelle la vitesse de tirage V se situe dans une sous-région de la marge comprenant 39% de la marge et une vitesse de tirage la plus basse de la sous-région est supérieure de 26% à une vitesse de tirage $V_{Pv/Pi}$ à la transition de la région Pv à une région Pi ; et

la séparation de la plaquette de la section du monocristal de diamètre uniforme, la portée $\Delta$V étant déterminée par la méthode de mesure spécifiée dans la description.

6. Procédé selon la revendication 5, comprenant l'augmentation de la pression partielle de l'hydrogène après que la portion du monocristal de diamètre uniforme a atteint une longueur axiale supérieure à 50% d'une longueur axiale prévue de ladite portion.

7. Procédé selon la revendication 5 ou la revendication 6, **caractérisé en ce qu'**une couche épitaxiale de silicium est déposée sur une face avant de la plaquette semi-conductrice.

8. Procédé selon la revendication 7, **caractérisé en ce qu'**avant le dépôt de la couche épitaxiale, le monocristal ou la plaquette semi-conductrice n'est pas soumis à un traitement thermique qui empêche la dissolution des noyaux de BMD pendant le dépôt de la couche épitaxiale par stabilisation.

**Fig. 1**

## Fig. 2A

## Fig. 2B

h [nm]

I [µm]

Fig. 3

Fig. 4

## Fig. 5

## Fig. 6

## Fig. 7

## Fig. 8

## Fig. 9

## Fig. 10

## Fig. 11

## Fig. 12

Fig. 13

**IN DER BESCHREIBUNG AUFGEFÜHRTE DOKUMENTE**

**In der Beschreibung aufgeführte Patentdokumente**

- US 20060150894 A1
- WO 9845508 A1
- EP 1887110 A1
- US 20110084366 A1
- US 20140044945 A1

**In der Beschreibung aufgeführte Nicht-Patentliteratur**

- **KAZUO MORIYA et al.** *J. Appl.Phys.,* 1989, vol. 66, 5267